(19) Europäisches Patentamt
European Patent Office
Office européen des brevets

(11) **EP 2 907 212 B1**

(12) **FASCICULE DE BREVET EUROPEEN**

(45) Date de publication et mention de la délivrance du brevet:
**24.05.2017 Bulletin 2017/21**

(21) Numéro de dépôt: **13774157.5**

(22) Date de dépôt: **08.10.2013**

(51) Int Cl.:
*G01R 31/36* (2006.01)   *H02J 3/32* (2006.01)
*H02J 7/00* (2006.01)   *H02J 7/04* (2006.01)

(86) Numéro de dépôt international:
**PCT/EP2013/070924**

(87) Numéro de publication internationale:
**WO 2014/056898 (17.04.2014 Gazette 2014/16)**

(54) **CENTRALE DE PILOTAGE D'UNE BATTERIE DE STOCKAGE D'ÉNERGIE**

**STEUERUNGEINHEIT FÜR EINER LEISTUNGSBATTERIE**

**ENERGY STORAGE BATTERY MANAGEMENT UNIT**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **09.10.2012 FR 1259624**

(43) Date de publication de la demande:
**19.08.2015 Bulletin 2015/34**

(73) Titulaire: **Electricité de France**
**75008 Paris (FR)**

(72) Inventeurs:
• **KHARRAT, Chady**
**F-78800 Houilles (FR)**
• **BEN-ABBES, Ala**
**F-92130 Issy les Moulineaux (FR)**

(74) Mandataire: **Regimbeau**
**139, rue Vendôme**
**69477 Lyon Cedex 06 (FR)**

(56) Documents cités:
**US-A1- 2012 074 909     US-A1- 2012 249 078**

**Description**

DOMAINE TECHNIQUE GENERAL ET CONTEXTE DE L'INVENTION

La présente invention se rapporte au domaine de la production électrique, plus précisément à une centrale de pilotage et au procédé associé pour commander une batterie de stockage d'énergie destinée à être couplée à une source de production électrique intermittente pour fournir à un réseau d'énergie électrique une puissance électrique totale lisse approchant une consigne de puissance totale suivant un plan de production annoncé à l'avance au gestionnaire de réseau.

Depuis quelques années la production d'énergie au moyen de sources de production électrique intermittentes, telles qu'éolienne, photovoltaïque, solaire, etc., connaît un essor sans précédent. De telles sources de production électrique intermittentes sont généralement regroupées en des fermes, par exemple dans le cas d'un champ d'éoliennes ou d'un ensemble de panneaux photovoltaïques, et raccordées à un réseau d'énergie électrique auquel elles fournissent de l'électricité. Dans ce document, nous désignerons par source de production électrique intermittente aussi bien une source isolée qu'une telle ferme constituée d'une pluralité de sources, dont le raccordement et la gestion de leur production sont centralisés, dans la mesure où le réseau d'énergie électrique ne voit qu'une centrale de production électrique.

Le caractère fatalement aléatoire de ces sources d'énergie impose des règles particulières à leur exploitation, notamment le lissage et la garantie de leur production suivant un plan annoncé à l'avance au gestionnaire du réseau électrique auquel elles sont raccordées, à défaut de quoi, malgré le profit économique qu'elles peuvent engendrer, leur intégration à grande échelle poserait de multiples problèmes.

En effet, la production de sources de production électrique intermittentes est souvent mal prévue et leurs variations peuvent entraîner des grands écarts par rapport au plan de production de référence annoncé au gestionnaire de réseau. Lorsque la puissance cumulée de ces productions intermittentes devient significative, elle peut mettre en péril l'équilibre offre-demande du système électrique et déstabiliser le réseau, les rendant alors peu attractives pour les gestionnaires de ce réseau.

Dans les faits, la puissance générée par une source de production électrique intermittente, largement variable d'un jour à l'autre, peut aussi subir de fortes fluctuations dans l'intervalle d'une heure ou de quelques minutes, dues aux variations météorologiques locales. Par exemple, une variation de la vitesse du vent entraîne une variation de la puissance électrique produite par une éolienne. De même, l'ensoleillement influe directement sur la production électrique d'un panneau photovoltaïque, et le passage d'un nuage perturbe celle-ci.

On conçoit aisément que si certaines variations peuvent être anticipées, au moyen par exemple de prévisions météorologiques, aucun modèle ne peut prévoir à l'avance une variation locale telle que le passage d'un nuage, phénomène transitoire et très local qui a pourtant de fortes répercussions sur la production électrique de panneaux photovoltaïques.

Une solution potentielle au problème d'imprévisibilité de la production électrique est apportée par l'utilisation de moyens de stockage d'énergie couplés à la source de production intermittente. Ces moyens de stockage contribuent à la fois à une gestion intelligente de l'énergie produite et à une amélioration de la qualité de la fourniture. En permettant le stockage d'énergies, ils permettent notamment diverses applications comme le lissage de la production, l'arbitrage de l'énergie, la participation aux services systèmes, le transfert de charge, le soulagement des contraintes sur le réseau de distribution électrique, etc...

Aujourd'hui, plusieurs types de stockage d'énergie existent : électrostatique (capacités), électromagnétique (supraconducteurs), électrochimique (batteries et supercapacités), gravitaire (stockages hydrauliques), inertiel (volant d'inertie) pneumatique ou encore thermique.

Parmi ces différentes technologies, le stockage par batterie présente actuellement des avantages majeurs de rapidité de réponse et de manoeuvrabilité, offrant plus de flexibilité et de stabilité au pilotage de l'installation de production constituée par la source de production électrique intermittente et la batterie de stockage qui lui est associée, ainsi qu'une puissance et une durée de vie relativement élevées. On appellera par la suite batterie de stockage d'énergie une ou plusieurs batteries individuelles reliées ensemble de sorte qu'elles soient commandées ensembles comme ne constituant qu'une batterie de stockage vis-à-vis de leur utilisation.

La batterie de stockage est utilisée pour stocker de l'énergie produite par la source de production électrique intermittente, et la restituer au réseau, en fonction des besoins. La bonne gestion de ces phases de charge et de décharge de la batterie permet d'absorber les variations de production électrique. Elle permet également de mieux adapter la puissance fournie au réseau dans la mesure où la production électrique d'une source de production électrique intermittente n'est pas facilement adaptable. L'utilisation d'une batterie de stockage peut ainsi contribuer à améliorer la prédictibilité de la fourniture et à stabiliser la production électrique.

Pour un moyen de stockage d'énergie telle qu'une batterie, la capacité à absorber les écarts de production dépend fortement de son dimensionnement et nécessite souvent de grandes capacités. Il est alors tentant de préconiser l'utilisation de batteries présentant de grandes capacités de stockage d'énergie. La plupart des techniques de pilotage présentées dans l'état de l'art supposent ainsi d'importantes capacités de stockage.

Cependant, dans la mesure où le coût d'exploitation d'une batterie est étroitement lié à son dimensionnement, une augmentation de la capacité requise d'une batterie peut accroître considérablement le coût du système, le rendant alors économiquement peu rentable.

Un moyen de contourner le problème de dimensionnement est de mieux planifier la trajectoire de l'état de charge de la batterie en fonction des incertitudes de prévisions. Ceci peut être réalisé par l'intermédiaire des algorithmes d'optimisation stochastique.

Ces méthodes de l'état de la technique sont censées permettre d'éviter l'épuisement de la batterie, c'est-à-dire son déchargement complet, ainsi que la saturation de la batterie, c'est-à-dire le dépassement de sa capacité de stockage. Ces deux situations laissent transmettre les fluctuations de la production de l'installation directement au réseau d'énergie électrique auquel est fournie l'énergie, et, dans le cas de la saturation, une perte d'énergie non stockable détériore le rendement de l'installation constituée par la source de production intermittente et la batterie de stockage.

L'inconvénient de ces méthodes stochastiques de gestion réside dans la sous-utilisation de la capacité de stockage en disponibilité. C'est aussi le cas de méthodes de commande prédictive censées garantir un compromis entre la régulation de l'état de charge à une consigne fixe et le lissage de la production de l'installation de production.

Certaines autres applications font appel à des batteries de stockage d'énergie qui ne sont pas couplée à une centrale de production électrique intermittente pour fournir à un réseau d'énergie électrique une puissance électrique totale suivant un plan de production, mais sont utilisées par un consommateur d'énergie électrique pour optimiser sa consommation d'électricité que lui fournit le réseau électrique, notamment en fonction de paramètres tels que la variation horaire du prix de l'électricité.

Par exemple, les documents US2012/074909 et US2012/249078 présentent de tels systèmes, dans lesquelles la charge ou la décharge d'une batterie est commandée en fonction de critères tels que le prix de l'électricité ou son impact écologique. Il est à noter que la batterie est alors chargée et déchargée à puissance constante maximale, dans une plage autorisée visant à maximiser l'espérance de vie de la batterie.

Cependant, de tels systèmes ne peuvent pas répondre à l'exigence de lissage d'une production électrique intermittente, ni à la garantie de la puissance électrique délivrée au point de rattachement au réseau électrique. Ils ne peuvent donc pas être mis en oeuvre de façon satisfaisante dans le cadre d'une centrale de production électrique intermittente destinée à fournir à un réseau électrique une puissance totale suivant un plan de production annoncé au gestionnaire du réseau.

PRESENTATION DE L'INVENTION

L'invention ci-après présente une alternative à ces méthodes qui ne donnent pas entièrement satisfaction, qui est à la fois simple à mettre en oeuvre, peu coûteuse, et permettant une bonne régulation de la production électrique sans nécessiter de grandes capacités de stockage d'énergie, afin de permettre à une centrale de production d'énergie intermittente de fournir à un réseau d'énergie électrique une puissance électrique totale lisse approchant une consigne suivant un plan de production annoncé à l'avance au gestionnaire du réseau.

L'invention propose à cet effet une centrale de pilotage d'une batterie de stockage d'énergie destinée à être couplée à une source de production électrique intermittente pour fournir à un réseau d'énergie électrique une puissance électrique totale approchant une consigne de puissance totale suivant un plan de production annoncé à l'avance au gestionnaire du réseau. La centrale de pilotage est adaptée pour déterminer une trajectoire de référence de l'état de charge de la batterie à partir d'une modélisation de la batterie et d'une consigne optimisée de puissance de batterie, ladite consigne optimisée de puissance de batterie étant déterminée à partir de la consigne de puissance totale, et pour mettre en oeuvre une régulation par asservissement en boucle fermée de l'état de charge de la batterie pour imposer le suivi par l'état de charge de la trajectoire de référence de l'état de charge de la batterie.

La régulation par asservissement en boucle fermée de l'état de charge de la batterie, activée en cas de forte dérive de l'état de charge de la batterie, permet d'ajuster la réponse dynamique de l'installation de production en anticipant les saturations ou les épuisements de la batterie tout en maintenant le lissage de la production totale de l'installation.

L'invention est avantageusement complétée par les différentes caractéristiques suivantes prises seules ou selon leurs différentes combinaisons possibles :

- la centrale est adaptée pour que la puissance électrique totale fournie au réseau approche au mieux la consigne de puissance totale tout en évitant la dérive de l'état de charge de la batterie;
- la centrale de pilotage est adaptée pour que la régulation par asservissement en boucle fermée de l'état de charge soit mise en oeuvre en cas de dérive de l'état de charge de la batterie par rapport à la trajectoire de référence de l'état de charge;
- la centrale de pilotage est adaptée pour que la dérive de l'état de charge corresponde au dépassement d'une bande morte définie autour d'une trajectoire de référence de l'état de charge de la batterie;

- la centrale de pilotage comprend des moyens de limitation de la régulation par asservissement en boucle fermée de l'état de charge aux seuls suivis de la trajectoire de référence de l'état de charge de la batterie qui éloignent l'état de charge des limites de la batterie;
- la régulation par asservissement en boucle fermée de l'état de charge prend en entrée la trajectoire de référence de l'état de charge et l'état de charge de la batterie pour fournir en sortie une consigne de puissance de batterie en boucle fermée;
- ladite centrale de pilotage commande la batterie au moyen d'une commande instantanée de puissance déterminée à partir:

  - d'une consigne de puissance de batterie en boucle fermée en sortie de la boucle de régulation, et
  - d'une consigne de puissance de batterie en boucle ouverte correspondant à la différence entre la consigne de production totale et la production instantanée de la source de production électrique intermittente;

- la consigne de puissance totale suit une trajectoire, et le pas de la régulation par asservissement en boucle fermée de l'état de charge est inférieur d'au moins un facteur cent par rapport au pas de la trajectoire suivie par la consigne de puissance totale.

L'invention concerne également une installation de production électrique comportant une batterie de stockage d'énergie destinée à être couplée à une source de production électrique intermittente pour fournir à un réseau d'énergie électrique une puissance électrique totale approchant une consigne de puissance totale suivant un plan de production annoncé à l'avance au gestionnaire du réseau, ladite installation comportant une centrale de pilotage selon l'invention. De préférence, l'installation comporte en outre une source de production électrique intermittente.

L'invention concerne aussi un procédé de pilotage d'une batterie de stockage d'énergie destinée à être couplée à une source de production électrique intermittente pour fournir à un réseau d'énergie électrique une puissance électrique totale approchant une consigne de puissance totale suivant un plan de production annoncé à l'avance au gestionnaire du réseau, dans lequel une trajectoire de référence de l'état de charge de la batterie est déterminée à partir d'une modélisation de la batterie et d'une consigne optimisée de puissance de batterie, ladite consigne optimisée de puissance de batterie étant déterminée à partir de la consigne de puissance totale, et une régulation par asservissement en boucle fermée de l'état de charge est mise en oeuvre pour imposer le suivi par l'état de charge de la trajectoire de référence de l'état de charge de la batterie.

Le procédé selon l'invention est avantageusement complété par les différentes caractéristiques suivantes prises seules ou selon leurs différentes combinaisons possibles :

- la régulation par asservissement en boucle fermée de l'état de charge est mise en oeuvre en cas de dérive de l'état de charge de la batterie par rapport à une valeur de référence de l'état de charge;
- la dérive de l'état de charge correspond au dépassement d'une bande morte définie autour d'une valeur de référence d'état de charge de la batterie;
- la régulation par asservissement en boucle fermée de l'état de charge est limitée aux seuls suivis de la trajectoire de référence de l'état de charge de la batterie qui éloignent l'état de charge des limites de la batterie.

L'invention concerne aussi un produit programme d'ordinateur comprenant des instructions de code de programme pour l'exécution des étapes du procédé selon l'invention, lorsque ledit programme est exécuté sur un ordinateur. De préférence, ce produit programme d'ordinateur prend la forme d'un support lisible par ordinateur sur lequel sont stockées lesdites instructions de code de programme.

PRESENTATION DES FIGURES

D'autres caractéristiques, buts et avantages de l'invention ressortiront de la description qui suit, qui est purement illustrative et non limitative, et qui doit être lue en regard des dessins annexés sur lesquels:

- la figure 1 est un schéma de principe illustrant une centrale de pilotage associée à sa batterie selon un mode de réalisation possible de l'invention;
- la figure 2 est un schéma de principe illustrant la boucle de régulation intervenant dans le système de la figure 1.

DESCRIPTION DETAILLEE

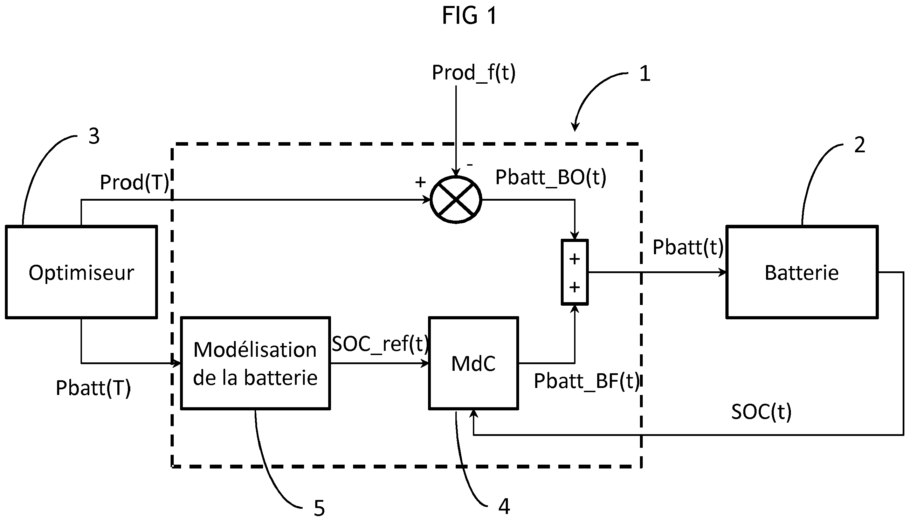

En référence à la figure 1, l'installation de production électrique comprend une centrale de pilotage 1 qui commande la puissance électrique de charge/décharge d'une batterie de stockage 2 au moyen d'une commande instantanée de puissance Pbatt(t), variable dans le temps. La batterie de stockage 2 est couplée à une source de production électrique intermittente pour fournir à un réseau d'énergie électrique une puissance électrique totale approchant une consigne de puissance totale Prod(T) suivant un plan de production annoncé à l'avance au gestionnaire du réseau.

La centrale de pilotage 1 reçoit d'un optimiseur 3 un plan de production totale constitué d'une séquence de consigne optimale de production totale Prod(T), variable dans le temps, avec un pas dit infra-journalier T d'une durée typique de 30 minutes. Ce plan de production totale est établi au moyen de prévisions de production, par exemple à partir de données météorologiques, ainsi que d'autres facteurs tels que le plan de charge du gestionnaire de réseau, ou l'anticipation de la demande de puissance sur le réseau. Le plan de production totale correspond à la production électrique totale de l'installation de production composée de la production électrique de la source intermittente et de la puissance délivrée par la batterie 2. Une installation idéale devrait suivre au plus près le plan de production totale.

La centrale de pilotage 1 reçoit une mesure instantanée de la production réelle de la source intermittente Prod_f(t) et adapte, en fonction de celle-ci, la puissance à fournir ou à consommer par la batterie 2 pour garantir le suivi du plan de production totale défini par l'optimiseur 3.

En effet, les erreurs de prévision, les perturbations météo imprévues et les fluctuations naturelles de la production de la source intermittente conduisent à un écart entre la production électrique instantanée Prod_f(t) de la source intermittente et la consigne optimale de puissance totale Prod(T) qui doit être fournie au réseau électrique, qui doit être compensé par la batterie 2, soit par le stockage de l'énergie produite en excédent, soit par la restitution d'énergie stockée dans la batterie 2. Ainsi, la centrale de pilotage 1 calcule une consigne de puissance de batterie en boucle ouverte Pbatt_BO(t), variable dans le temps, qui sert à déterminer une commande instantanée de puissance de batterie Pbatt(t), variable dans le temps, afin de commander la batterie 2.

La consigne de puissance de batterie en boucle ouverte Pbatt_BO(t) correspondant à la commande de puissance demandée à la batterie 2 est donc calculée en boucle ouverte à chaque instant t par Pbatt_BO(t) = Prod(T) - Prod_f(t).

Cependant, la seule commande en boucle ouverte de la puissance de la batterie peut conduire à l'épuisement ou à la saturation de la batterie en cas d'écart trop important et/ou trop prolongé entre la production électrique instantanée Prod_f(t) de la source intermittente et la consigne optimale de production totale Prod(T).

Afin de mieux tirer parti de la batterie, l'optimiseur 3 détermine également une consigne optimisée de puissance de batterie Pbatt(T), variable dans le temps, qui est fournie à la centrale de pilotage 1. La consigne optimisée de puissance de batterie Pbatt(T) correspond à un plan de stockage d'énergie qui est déterminée par l'optimiseur 3 pour la commande de la batterie 2 afin de permettre de répondre au mieux au plan de production totale, compte tenu des variations anticipées de la production de la source intermittente, que la batterie 2 doit compenser.

Par exemple, il peut être prévu que la production de la source intermittente ne sera pas suffisante pour assurer la production électrique requise pendant une période donnée, le plan de stockage d'énergie peut alors prévoir un stockage préventif d'énergie antérieurement à cette période donnée afin de disposer, pendant ladite période donnée, de suffisamment d'énergie pour permettre le suivi du plan de production totale.

La centrale de pilotage 1 a pour rôle d'assurer durant chaque pas infra-journalier T le suivi instantané de la consigne optimale de puissance totale Prod(T). Dans un cas idéal, la production fournie par la source de production intermittente en temps-réel est égale à sa prévision et le suivi de la consigne optimale de puissance totale Prod(T) est garanti par la simple application de la consigne optimisée de puissance de batterie Pbatt(T) calculé lui aussi par l'optimiseur 3.

Cependant, là encore, des erreurs de prévision, les perturbations météo imprévues et les fluctuations naturelles de la production de la source intermittente peuvent conduire à des écarts trop grand entre la production électrique de la source intermittente et le plan de production, résultant en des épuisements ou des saturations de la batterie de stockage 2. Dans ce cas, la batterie 2 ne pouvant absorber les fluctuations de la production électrique, celles-ci sont directement transmises au réseau.

Pour éviter de telles situations, la centrale de pilotage 1 comprend un module de maintien de charge MdC 4 couplé à une modélisation de la batterie 5, les deux opérant en temps-réel à une fréquence fixe et intégrés à la chaîne d'optimisation classique des consignes de la batterie, i.e. l'optimiseur 3.

L'objectif principal est de compenser les erreurs de prévisions et les fluctuations de production tout en surveillant et en contrôlant l'état de charge de la batterie 2 dans le but d'éviter au mieux les épuisements et les saturations conduisant à l'invalidité de la batterie 2, c'est-à-dire à sa non-disponibilité en raison d'un manque ou d'une saturation d'énergie stockée.

La centrale de pilotage 1 est adaptée pour déterminer une trajectoire de référence de l'état de charge de la batterie SOC_ref(t) à partir d'une modélisation de la batterie 5 et d'une consigne optimisée de puissance de batterie Pbatt(T), ladite consigne optimisée de puissance de batterie Pbatt(T) étant déterminée à partir de la consigne de puissance totale Prod(T).

La modélisation de la batterie 5 traduit la relation et les contraintes entre la puissance demandée à la batterie 2 (en charge ou en décharge) et la charge que celle-ci doit présenter pour y répondre. La modélisation de la batterie 5 prend en entrée la consigne optimisée de puissance de batterie Pbatt(T) et fournit en sortie une trajectoire de référence de l'état de charge SOC_ref(t).

La trajectoire de référence de l'état de charge SOC_ref(t) de la batterie 2 est une suite temporelle de valeurs de référence dudit état de charge SOC(t). Cette trajectoire de référence de l'état de charge SOC_ref(t) représente l'évolution de la charge de batterie qui doit être suivie pour que la batterie 2 soit en mesure de répondre aux sollicitations de puissance du suivi de la consigne optimisée de puissance de batterie Pbatt(T).

Du point de vue de l'état de charge de la batterie 2, la consigne de puissance de batterie en boucle ouverte Pbatt_BO(t), différente de la consigne optimisée de puissance de batterie Pbatt(T), est perçue comme une perturbation qui résulte en une déviation de l'état de charge SOC(t) par rapport à sa trajectoire de référence de l'état de charge SOC_ref(t). Cette dernière est calculée par un modèle simplifié de la batterie en fonction de la production prévue Pbatt(T) pour le pas infra-journalier T en cours :

$$SOC\_ref(t) = SOC\_ref(t-1) + Te\left(\frac{1}{\eta_{dech}} Pbatt^+(T) + \eta_{ch}.Pbatt^-(T)\right)$$

avec

$$Pbatt^+(T) = \begin{cases} Pbatt(T) & si\ Pbatt(T) > 0 \\ 0 & si\ Pbatt(T) \leq 0 \end{cases}$$

et

$$Pbatt^-(T) = \begin{cases} Pbatt(T) & si\ Pbatt(T) < 0 \\ 0 & si\ Pbatt(T) \geq 0 \end{cases}$$

où $\eta_{ch}$ et $\eta_{dech}$ sont respectivement le rendement de charge et de décharge de la batterie 2 et Te est le pas d'échantillonnage de la modélisation de la batterie 5. La modélisation de la batterie 5 est un modèle simplifié donné à titre purement illustratif, des modèles plus complexes et plus fiables de batterie pouvant être envisagés, dans lesquels la trajectoire de référence de l'état de charge SOC_ref(t) en sortie n'est pas exprimé linéairement en fonction de la puissance de charge ou de décharge.

Toutefois, la compensation des écarts de production de la source de production par rapport à sa prévision peut engendrer des déviations de l'état de charge SOC(t) par rapport à sa trajectoire optimisée SOC_ref(t), qui en se cumulant peuvent amener l'état de charge SOC(t) vers ses limites d'épuisement ou de saturation de la batterie 2. Dans de tels cas, la batterie 2 ne pouvant plus charger ou décharger, les fluctuations de la production de la source intermittente seront directement transmises au réseau électrique.

Afin d'éviter ces situations, la centrale de pilotage 1 est adaptée pour mettre en oeuvre une régulation par asservissement en boucle fermée de l'état de charge SOC(t) pour imposer le suivi de la trajectoire de référence de l'état de charge de la batterie SOC_ref(t). Cette régulation par asservissement en boucle fermée de l'état de charge SOC(t) est mise en oeuvre en cas de dérive de l'état de charge de la batterie par rapport à la trajectoire de référence de l'état de charge de la batterie SOC_ref(t), la dérive de l'état de charge correspondant au dépassement d'une bande morte définie autour d'une valeur de référence d'état de charge SOC(t) de la batterie 2.

La centrale de pilotage est adaptée pour que la puissance électrique totale fournie au réseau approche au mieux la consigne de puissance totale Prod(T) tout en évitant la dérive de l'état de charge SOC(t) de la batterie.

En effet, une déviation de l'état de charge SOC(t) de la batterie 2 par rapport à sa référence, tolérée pour des niveaux de charge moyens, devient problématique pour des niveaux proches des limites de stockage de la batterie 2, pouvant conduire à l'épuisement ou la saturation de la batterie 2. Dans les faits, une telle situation se traduit par la transmission des fluctuations de la source de production intermittente sur le réseau électrique, la batterie 2 étant alors incapable de les compenser.

C'est pourquoi la régulation par asservissement en boucle fermée de l'état de charge SOC(t) s'active en cas du dépassement par l'état de charge SOC(t) d'une bande morte définie autour d'une valeur de référence d'état de charge SOC(t) de la batterie 2. Cette valeur de référence est de préférence sa valeur moyenne, et la bande morte est définie avec hystérésis autour de cette valeur moyenne définie par :

$$SOC\_moy = \frac{SOC\_sup + SOC\_inf}{2}$$

où SOC_sup et SOC_inf sont respectivement les limites supérieure et inférieure de l'état de charge SOC(t).

De préférence, les limites supérieur et inférieur de l'état de charge sont mises à jour en fonction d'un historique de l'état de charge SOC(t), afin de prendre en compte les variations des limites physiques de stockage de la batterie 2.

Cette régulation par asservissement en boucle fermée se charge de réguler l'état de charge SOC(t) pour suivre la trajectoire de référence SOC_ref(T) en corrigeant dynamiquement la commande de puissance instantanée Pbatt(t) à charger ou à décharger par la batterie 2. Pour un état de charge bas (respectivement haut), les écarts positifs (respectivement négatifs) entre l'état de charge SOC(t) mesuré et sa trajectoire de référence SOC_ref(T) sont tolérés, et seuls les écarts négatifs (respectivement positifs) sont compensés. Les épuisements et les saturations sont alors évités en forçant le suivi de la trajectoire de référence de l'état de charge SOC_ref(t) déterminée au moyen de la modélisation de la batterie 5 et les consignes envoyées par les optimiseurs.

Ceci est réalisé par l'intermédiaire d'une réponse transitoire de la batterie 2 dont le comportement dynamique (temps de réponse, dépassement, écart en régime permanent, etc.) est maitrisé par les paramètres de configuration ajustables. Cette régulation temps-réel fonctionne à un pas d'échantillonnage de l'ordre de la seconde (entre 1 et 10 secondes), fixé en fonction de la fréquence d'acquisition et de traitement des mesures.

En contraste, la consigne de puissance totale Prod(T) et la consigne optimisée de puissance de batterie Pbatt(T) ont un pas d'échantillonnage beaucoup plus long, au moins d'un facteur dix ou cent. Typiquement, ce pas d'échantillonnage est d'au moins 30 minutes. En effet, ces consignes résultent de mécanismes d'optimisation journalier et infra-journalier, mais ne sont pas instantanés. On note ainsi avec T les instants correspondants à des paliers d'échantillonnage au moins infra-journalier, et t les instants correspondants à des paliers d'échantillonnage instantanés, de l'ordre de 1 à 10 secondes.

Ainsi, la consigne de puissance totale Prod(T) suit une trajectoire, et le pas de la régulation par asservissement en boucle fermée de l'état de charge est inférieur d'au moins un facteur cent par rapport au pas de la trajectoire suivie par la consigne de puissance totale Prod (T).

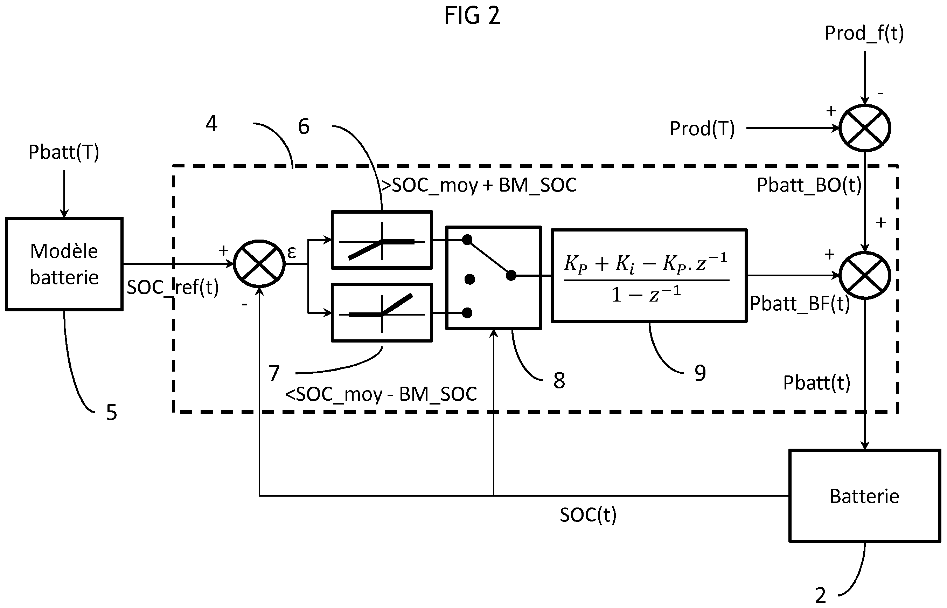

La figure 2 illustre un mode de réalisation possible de la régulation mise en oeuvre dans le module de maintien de charge 4. Une mesure instantanée de l'état de charge SOC(t) de la batterie 2 est acquis ou fourni au module de maintien de charge 4.

L'état de charge SOC(t) est comparé à la trajectoire de référence d'état de charge SOC_ref(t) selon:

$$\varepsilon = SOC\_ref(t) - SOC(t)$$

L'écart $\varepsilon$ qui en résulte n'est pris en compte pour qu'en fonction du niveau de l'état de charge SOC(t) par rapport à un niveau moyen encadré par une bande morte.

La centrale de pilotage 1 met ainsi en oeuvre un traitement différent pour un suivi de trajectoire de référence de l'état de charge de la batterie SOC_ref(t) qui éloigne l'état de charge SOC(t) des limites de la batterie 2, et pour un suivi de trajectoire de référence de l'état de charge de la batterie SOC_ref(t) qui rapproche l'état de charge SOC(t) des limites de la batterie 2. Dans le premier cas, la régulation par asservissement en boucle fermée de l'état de charge SOC(t) est mise en oeuvre, tandis que dans le second cas, la régulation par asservissement en boucle fermée de l'état de charge n'est pas mise en oeuvre.

Dans le mode de réalisation illustré, l'écart entre la trajectoire de référence d'état de charge SOC_ref(t) et l'état de charge SOC(t) est fourni à deux dispositifs à seuil 6, 7, qui ne transmettent que les écarts $\varepsilon$ négatifs ou positifs, respectivement. Ces deux dispositifs à seuil 6, 7 constituent des moyens de limitation de la régulation par asservissement en boucle fermée de l'état de charge SOC(t) aux seuls suivis de la trajectoire de référence de l'état de charge de la batterie SOC_ref(t) qui éloignent l'état de charge SOC(t) des limites de la batterie.

Un commutateur 8 effectue la commutation entre les dispositifs à seuil 6, 7 et un état déconnecté, en fonction de l'état de charge SOC(t), pour transmettre, soit les écarts positifs en cas de connexion avec le dispositif à seuil 6, soit les écarts négatifs en cas de connexion avec le dispositif à seuil 7, soit rien, au correcteur Proportionnel-Intégral 9.

Dans le cas où l'état de charge de la batterie SOC(t) se situe à l'intérieur d'une bande morte centrée sur une valeur moyenne de l'état de charge SOC_moy, le commutateur 8 ne transmet aucun écart (position centrale sur la figure 2).

Dans le cas où l'état de charge SOC(t) de la batterie est supérieur à une limite haute correspondant au dépassement par la borne supérieure de la bande morte centrée sur la valeur moyenne de l'état de charge SOC_moy, alors le commutateur 8 établit une connexion entre le dispositif à seuil 6 et le correcteur 9. Il s'agit de la configuration illustrée par la figure 2. La batterie 2 est alors proche de sa saturation, et menace de ne plus être en mesure d'assurer son rôle de compensation, par l'impossibilité d'absorber un supplément d'énergie.

Le dispositif à seuil 6 ne laisse passer que les écarts négatifs, les autres étant ramenés à zéro, le correcteur 9 n'a d'entrées non nulles que lorsque l'état de charge de la batterie SOC(t) est supérieur à la trajectoire de référence SOC_ref(t). Dans ce cas, la régulation mise en oeuvre par le correcteur 9 vise à ramener l'état de charge SOC(t) vers la trajectoire de charge SOC_ref(t), qui lui est inférieur, ce qui correspond à une baisse de l'énergie stockée dans la batterie 2.

A l'inverse, si l'état de charge de la batterie SOC(t) est inférieur à la trajectoire de référence SOC_ref(t), l'écart est positif, et, en raison du dispositif à seuil 6, le correcteur reçoit une entrée nulle, de sorte qu'aucune correction n'est apportée.

De la sorte, pour un état de charge trop haut de la batterie, les écarts positifs entre la trajectoire de charge SOC_ref(t) et l'état de charge SOC(t) sont tolérés, tandis que les écarts $\varepsilon$ négatifs sont compensés.

Lorsque le suivi de la trajectoire de référence SOC_ref(t) entraîne une demande de stockage d'énergie à la batterie 2, c'est-à-dire lorsque l'écart est positif, ce suivi n'est plus assuré. En revanche, lorsque le suivi de la trajectoire de référence SOC_ref(t) entraîne une diminution de l'énergie stockée dans la batterie 2, c'est-à-dire lorsque l'écart est négatif, le suivi de la trajectoire de référence SOC_ref(t) permet d'éloigner l'état de charge des limites physiques de stockage, et donc de conserver la capacité de la batterie 2 à absorber les fluctuations.

De la même manière, dans le cas où l'état de charge SOC(t) de la batterie est inférieur à une limite basse correspondant au dépassement par la borne inférieure d'une bande morte centrée sur une valeur moyenne de l'état de charge SOC_moy, alors le commutateur 8 établit une connexion entre le dispositif à seuil 7 et le correcteur 9. La batterie 2 est alors fortement déchargée, et menace de ne plus être en mesure d'assurer son rôle de compensation, par manque d'énergie stockée.

Le dispositif à seuil 7 ne laisse passer que les écarts positifs, les autres étant ramenés à zéro, le correcteur 9 n'a d'entrées non nulles que lorsque l'état de charge de la batterie SOC(t) est inférieur à la trajectoire de référence SOC_ref(t). Dans ce cas, la régulation mise en oeuvre par le correcteur 9 vise à ramener l'état de charge SOC(t) vers la trajectoire de charge SOC_ref(t), qui lui est supérieur, ce qui correspond à une hausse de l'énergie stockée dans la batterie 2.

A l'inverse, si l'état de charge de la batterie SOC(t) est supérieur à la trajectoire de référence SOC_ref(t), l'écart est négatif, et, en raison du dispositif à seuil 7, le correcteur reçoit une entrée nulle, de sorte qu'aucune correction n'est apportée. Ainsi, pour un état de charge trop bas de la batterie, les écarts $\varepsilon$ négatifs entre la trajectoire de charge SOC_ref(t) et l'état de charge SOC(t) sont tolérés, tandis que les écarts $\varepsilon$ positifs sont compensés.

De la sorte, lorsque le suivi de la trajectoire de référence SOC_ref(t) entraîne une demande de puissance à la batterie 2, c'est-à-dire lorsque l'écart $\varepsilon$ est négatif, ce suivi n'est plus assuré. En revanche, lorsque le suivi de la trajectoire de référence SOC_ref(t) entraîne une augmentation de l'énergie stockée dans la batterie 2, c'est-à-dire lorsque l'écart est positif, le suivi de la trajectoire de référence SOC_ref(t) permet d'éloigner l'état de charge des limites physiques de stockage, et donc de conserver la capacité de la batterie 2 à absorber les fluctuations.

Une telle approche permet d'éviter une dérive de l'état de charge SOC(t) vers les limites (basse et haute) physiques de stockage.

Le correcteur 9 calcule une consigne de puissance de batterie en boucle fermée (Pbatt_BF(t)), qui est additionnée à la consigne de puissance de batterie en boucle ouverte (Pbatt_BO(t)) pour donner la commande instantanée de batterie Pbatt(t), qui est appliquée à la batterie 2 pour la commander.

Ainsi, la centrale de pilotage commande la batterie 2 au moyen d'une commande instantanée de puissance Pbatt(t) déterminée à partir:

- d'une consigne de puissance de batterie en boucle fermée Pbatt_BF(t) en sortie de la boucle de régulation, et
- d'une consigne de puissance de batterie en boucle ouverte Pbatt_BO(t) correspondant à la différence entre la consigne de production totale Prod(T) et la production instantanée Prod_f(t) de la source de production électrique intermittente.

Le correcteur 9 utilisé pour la régulation de l'état de charge SOC(t) est un filtre Proportionnel-Intégrale (PI) qui permet d'ajuster le comportement transitoire de la réaction « anticipative ».

Les deux paramètres $K_P$ (gain proportionnel) et $K_i$ (gain intégral) du correcteur 9 déterminent le temps de réponse et la bande passante du système bouclé ainsi que l'amplitude de la consigne de puissance de batterie en boucle fermée (Pbatt_BF(t)). Plus $K_P$ et $K_i$ sont élevés et plus la réaction est accélérée en dépit d'une commande à forte amplitude. L'effet des variations de la consigne de puissance de batterie en boucle ouverte (Pbatt_BO(t) sur la consigne de puissance de batterie en boucle fermée Pbatt_BF(t), par suite sur la puissance totale fournie au réseau, est moins filtré.

En revanche et pour de faibles valeurs de $K_P$ et $K_i$, l'effet des variations de la consigne de puissance de batterie en boucle ouverte Pbatt_BO(t) sur la consigne de puissance de batterie en boucle fermée Pbatt_BF(t) est négligeable mais le temps de réponse de la réaction est plus long. Le réglage de ces paramètres se fait en fonction de la réponse désirée, de la fréquence des variations de Pbatt_BO(t) qui sont directement liés aux fluctuations de la production de la source de production électrique intermittente et des exigences de l'exploitant de la batterie 2 en termes de sollicitations de la batterie 2 et de durée de vie.

L'invention concerne également une installation de production électrique comportant une batterie 2 de stockage d'énergie destinée à être couplée à une source de production électrique intermittente pour suivre une consigne de puissance totale , ladite installation comportant une centrale de pilotage 1 selon l'invention. De préférence, l'installation comporte en outre une source de production électrique intermittente.

L'invention concerne aussi un procédé de pilotage de la batterie de stockage conforme à la mise en oeuvre de la centrale de pilotage selon l'invention.

## Revendications

1. Centrale de pilotage d'une batterie (2) de stockage d'énergie destinée à être couplée à une source de production électrique intermittente pour fournir à un réseau d'énergie électrique une puissance électrique totale approchant une consigne de puissance totale (Prod (T)) suivant un plan de production annoncé à l'avance au gestionnaire du réseau,
**caractérisée en ce que** la centrale de pilotage (1) est adaptée pour déterminer une trajectoire de référence de l'état de charge de la batterie (SOC_ref(t)) à partir d'une modélisation de la batterie (5) et d'une consigne optimisée de puissance de batterie (Pbatt(T)), ladite consigne optimisée de puissance de batterie (Pbatt(T)) étant déterminée à partir de la consigne de puissance totale (Prod(T)), et
**en ce que** la centrale de pilotage (1) est adaptée pour mettre en oeuvre une régulation par asservissement en boucle fermée de l'état de charge (SOC(t)) de la batterie (5) pour imposer le suivi par l'état de charge (SOC(t)) de la trajectoire de référence de l'état de charge de la batterie (SOC_ref(t)).

2. Centrale de pilotage selon la revendication précédente, ladite centrale étant adaptée pour que la puissance électrique totale fournie au réseau approche au mieux la consigne de puissance totale (Prod(T)) tout en évitant la dérive de l'état de charge (SOC(t)).

3. Centrale de pilotage selon l'une des revendications précédentes, ladite centrale étant adaptée pour que la régulation par asservissement en boucle fermée de l'état de charge soit mise en oeuvre en cas de dérive de l'état de charge (SOC(t)) de la batterie par rapport à la trajectoire de référence de l'état de charge.

4. Centrale de pilotage selon la revendication précédente, ladite centrale étant adaptée pour que la dérive de l'état de charge corresponde au dépassement d'une bande morte définie autour d'une trajectoire de référence de l'état de charge (SOC(t)) de la batterie (2).

5. Centrale de pilotage selon l'une des revendications précédentes, comprenant des moyens de limitation (6,7) de la régulation par asservissement en boucle fermée de l'état de charge aux seuls suivis de la trajectoire de référence de l'état de charge de la batterie (SOC_ref(t)) qui éloignent l'état de charge (SOC(t)) des limites de la batterie.

6. Centrale de pilotage selon l'une des revendications précédentes, dans laquelle la régulation par asservissement en boucle fermée de l'état de charge prend en entrée la trajectoire de référence de l'état de charge (SOC_ref(t)) et l'état de charge de la batterie (SOC(t)) pour fournir en sortie une consigne de puissance de batterie en boucle fermée (Pbatt_BF(t)).

7. Centrale de pilotage selon l'une des revendications précédentes, ladite centrale de pilotage commandant la batterie (2) au moyen d'une commande instantanée de puissance (Pbatt(t)) déterminée à partir

- d'une consigne de puissance de batterie en boucle fermée (Pbatt_BF(t)) en sortie de la boucle de régulation, et
- d'une consigne de puissance de batterie en boucle ouverte (Pbatt_BO(t)) correspondant à la différence entre la consigne de production totale (Prod(T)) et la production instantanée (Prod_f(t)) de la source de production électrique intermittente.

8. Centrale de pilotage selon l'une des revendications précédentes, dans laquelle la consigne de puissance totale (Prod (T)) suit une trajectoire, et le pas de la régulation en boucle fermée de l'état de charge est inférieur d'au moins un facteur cent par rapport au pas de la trajectoire suivie par la consigne de puissance totale (Prod (T)).

9. Installation de production électrique comportant une batterie (2) de stockage d'énergie destinée à être couplée à une source de production électrique intermittente pour fournir à un réseau d'énergie électrique une puissance électrique totale approchant une consigne de puissance totale (Prod (T)) suivant un plan de production annoncé à l'avance au gestionnaire du réseau, **caractérisé en ce que** ladite installation comporte une centrale de pilotage (1) selon l'une quelconque des revendications précédentes.

10. Installation de production électrique selon la revendication précédente, comportant en outre une source de production électrique intermittente.

11. Procédé de pilotage d'une batterie (2) de stockage d'énergie destinée à être couplée à une source de production électrique intermittente pour fournir à un réseau d'énergie électrique une puissance électrique totale approchant une consigne de puissance totale (Prod (T)) suivant un plan de production annoncé à l'avance au gestionnaire du réseau,
**caractérisé en ce qu'**une trajectoire de référence de l'état de charge de la batterie (SOC_ref(t)) est déterminée à partir d'une modélisation de la batterie (5) et d'une consigne optimisée de puissance de batterie (Pbatt(T)), ladite consigne optimisée de puissance de batterie (Pbatt(T)) étant déterminée à partir de la consigne de puissance totale (Prod(T)), et
une régulation par asservissement en boucle fermée de l'état de charge est mise en oeuvre pour imposer le suivi par l'état de charge SOC(t) de la trajectoire de référence de l'état de charge de la batterie (SOC_ref(t)).

12. Produit programme d'ordinateur comprenant des instructions de code de programme pour l'exécution des étapes du procédé selon la revendication 11, lorsque ledit programme est exécuté sur un ordinateur.

**Patentansprüche**

1. Steuerzentrale einer Energiespeicherbatterie (2), die vorgesehen ist, an eine intermittierende Stromproduktionsquelle gekoppelt zu sein, um einem Stromnetz eine elektrische Gesamtleistung bereitzustellen, die sich gemäß einem dem Verteilnetzbetreiber zuvor mitgeteiltem Produktionsplan einem Gesamt-Leistungssollwert (Prod (T)) nähert,
**dadurch gekennzeichnet, dass** die Steuerzentrale (1) ausgebildet ist, um eine Referenzlinie des Ladezustands der Batterie (SOC ref(t)) auf der Basis einer Modellierung der Batterie (5) und eines optimierten Leistungssollwerts der Batterie (Pbatt(T)) zu bestimmen, wobei der optimierte Leistungssollwert der Batterie (Pbatt(T)) auf der Basis des Gesamt-Leistungssollwerts (Prod(T)) bestimmt wird, und
dass die Steuerzentrale (1) ausgebildet ist, um eine Regelung durch Steuerung bei geschlossenem Wirkungskreis des Ladezustands (SOC(t)) der Batterie (5) durchzuführen, um das Tracking der Referenzlinie des Ladezustands der Batterie (SOC ref(t)) mittels Ladezustand (SOC(t)) zu veranlassen.

2. Steuerzentrale nach vorangehendem Anspruch, wobei die Zentrale ausgebildet ist, damit sich die dem Netz bereitgestellte elektrische Gesamtleistung bestmöglich dem Gesamt-Leistungssollwert (Prod(T)) bei Vermeidung von Drift des Ladezustands (SOC(t)) nähert.

3. Steuerzentrale nach einem der vorangehenden Ansprüche, wobei die Zentrale ausgebildet ist, damit die Regelung des Ladezustands durch Steuerung bei geschlossenem Wirkungskreis bei Drift des Ladezustands (SOC(t)) der Batterie in Bezug auf die Referenzlinie des Ladezustands durchgeführt wird.

4. Steuerzentrale nach vorangehendem Anspruch, wobei die Zentrale ausgebildet ist, damit die Drift des Ladezustands der Überschreitung eines Totbands, definiert um eine Referenzlinie des Ladezustands (SOC(t)) der Batterie (2), entspricht.

5. Steuerzentrale nach einem der vorangehenden Ansprüche, umfassend Begrenzungsmittel (6, 7) der Regelung des Ladezustands durch Steuerung bei geschlossenem Wirkungskreis allein mittels Trackings der Referenzlinie des Ladezustands der Batterie (SOC_ref(t)), die den Ladezustand (SOC(t)) von den Limits der Batterie entfernen.

6. Steuerzentrale nach einem der vorangehenden Ansprüche, wobei die Regelung durch Steuerung bei geschlossenen Wirkungskreis des Ladezustands eingangs die Referenzlinie des Ladezustands (SOC_ref(t)) und den Ladezustand der Batterie (SOC(t)) verwendet, um am Ausgang einen Leistungssollwert der Batterie bei geschlossenem Wirkungskreis (Pbatt_BF(t)) bereitzustellen.

7. Steuerzentrale nach einem der vorangehenden Ansprüche, wobei die Steuerzentrale die Batterie (2) mittels einer Leistungsmomentsteuerung (Pbatt(t)) steuert, die bestimmt wird auf der Basis

- eines Leistungssollwerts der Batterie bei geschlossenen Wirkungskreis (Pbatt_BF(t)) am Ausgang des Regelungswirkungskreises, und
- eines Leistungssollwerts der Batterie bei geöffnetem Wirkungskreis (Pbatt_BO(t)), der der Differenz zwischen dem Gesamt-Produktionssollwert (Prod(T)) und der momentanen Produktion (Prod_f(t)) der intermittierenden Stromproduktionsquelle entspricht.

8. Steuerzentrale nach einem der vorangehenden Ansprüche, wobei der Gesamt-Leistungssollwert (Prod (T)) einer Kurve folgt, und der Regelungsschritt bei geschlossenem Wirkungskreis des Ladezustands in Bezug zum Schritt der Kurve, die vom Gesamt-Leistungssollwert (Prod (T)) getrackt wird, mindestens um einen Faktor Einhundert kleiner ist.

9. Anlage für die Produktion von Strom, aufweisend eine Energiespeicherbatterie (2), die vorgesehen ist, an eine intermittierende Stromproduktionsquelle gekoppelt zu sein, um einem Stromnetz eine elektrische Gesamtleistung bereitzustellen, die sich gemäß einem dem Verteilnetzbetreiber zuvor mitgeteiltem Produktionsplan einem Gesamt-Leistungssollwert (Prod (T)) nähert, **dadurch gekennzeichnet, dass** die Anlage eine Steuerzentrale (1) nach einem der vorangehenden Ansprüche aufweist.

10. Anlage für die Produktion von Strom nach vorangehendem Anspruch, aufweisend ferner eine intermittierende Stromproduktionsquelle.

11. Verfahren zum Steuern einer Energiespeicherbatterie (2), die vorgesehen ist, an eine intermittierende Stromproduktionsquelle gekoppelt zu sein, um einem Stromnetz eine elektrische Gesamtleistung bereitzustellen, die sich gemäß einem dem Verteilnetzbetreiber zuvor mitgeteiltem Produktionsplan einem Gesamt-Leistungssollwert (Prod (T)) nähert,
**dadurch gekennzeichnet, dass** eine Referenzlinie des Ladezustands der Batterie (SOC_ref(t)) auf der Basis einer Modellierung der Batterie (5) und eines optimierten Leistungssollwerts der Batterie (Pbatt(T)) bestimmt wird, wobei der optimierte Leistungssollwert der Batterie (Pbatt(T)) auf der Basis des Gesamt-Leistungssollwerts (Prod(T)) bestimmt wird, und
eine Regelung durch Steuerung des Ladezustands bei geschlossenem Wirkungskreis durchgeführt wird, um das Tracking der Referenzlinie des Ladezustands der Batterie (SOC_ref(t)) mittels Ladezustand (SOC(t)) zu veranlassen.

12. Computerprogrammprodukt, umfassend Programmcodebefehle für die Ausführung der Schritte des Verfahrens nach Anspruch 11, wenn das Programm auf einem Computer ausgeführt wird.


**Claims**

1. A control central of a power storage battery (2) intended to be coupled to a source of intermittent electrical production for supplying an electric power network with total electric power approaching a total power setpoint (Prod (T)) according to a production plan announced in advance to the manager of the network,
**characterized in that** the control central (1) is adapted to determine a reference trajectory of the state of charge of the battery (SOC_ref(t)) from a model (5) of the battery and an optimised setpoint of battery power (Pbatt(T)), said optimised battery power setpoint (Pbatt(T)) being determined from the total power setpoint (Prod(T)), and
**in that** the control central (1) is adapted to perform regulation via closed-loop feedback control of the state of charge (SOC(t)) of the battery (5) to impose tracking by the state of charge (SOC(t)) of the reference trajectory of the state of charge of the battery (SOC_ref(t)).

2. The control central according to the preceding claim, said central being adapted so that the total electric power supplied to the network best approaches the total power setpoint (Prod(T)) and avoids drift of the state of charge (SOC(t)).

3. The control central according to one of the preceding claims, said central being adapted so that regulation via closed-loop feedback control of the state of charge is performed in case of drift of the state of charge (SOC(t)) of the battery relative to the reference trajectory of the state of charge.

4. The control central according to the preceding claim, said central being adapted so that the drift of the state of charge corresponds to exceeding a dead band defined around a reference trajectory of the state of charge (SOC(t)) of the battery (2).

5. The control central according to one of the preceding claims, comprising regulation limitation means (6, 7) via closed-loop feedback control of the state of charge to the only follow-up of the reference trajectory of the state of charge of the battery (SOC_ref(t)) which move the state of charge (SOC(t)) away from the limits of the battery.

6. The control central according to one of the preceding claims, wherein regulation via closed-loop feedback control of the state of charge inputs the reference trajectory of the state of charge (SOC_ref(t)) and the state of charge of the battery (SOC(t)) to supply at output a closed-loop battery power setpoint (Pbatt_BF(t)).

7. The control central according to one of the preceding claims, said control central controlling the battery (2) by means of an instantaneous power command (Pbatt(t)) determined from

- a closed-loop battery power setpoint (Pbatt_BF(t)) at output of the regulation loop, and
- an open-loop battery power setpoint (Pbatt_BO(t)) corresponding to the difference between the total production setpoint (Prod(T)) and the instantaneous production (Prod_f(t)) of the source of intermittent electrical production.

8. The control central according to one of the preceding claims, wherein the total power setpoint (Prod (T)) follows a trajectory, and the period of the regulation closed-loop of the state of charge is less by at least a hundred times relative to the period of the trajectory followed by the total power setpoint (Prod (T)).

9. An electrical production installation comprising a power storage battery (2) intended to be coupled to a source of intermittent electrical production to supply an electric power network with total electric power approaching a total power setpoint (Prod (T)) according to a production plan announced in advance to the manager of the network, **characterized in that** said installation comprises a control central (1) according to one of the preceding claims.

10. The electrical production installation according to the preceding claim, further comprising a source of intermittent electrical production.

11. A method for controlling a power storage battery (2) intended to be coupled to a source of intermittent electrical production to supply an electric power network with total electric power approaching a total power setpoint (Prod (T)) according to a production plan announced in advance to the manager of the network, **characterized in that** a reference trajectory of the state of charge of the battery (SOC_ref(t)) is determined from a model (5) of the battery and an optimised battery power setpoint (Pbatt(T)), said optimised battery power setpoint (Pbatt(T)) being determined from the total power setpoint (Prod(T)), and regulation via closed-loop feedback control of the state of charge is performed to impose tracking by the state of charge SOC(t) of the reference trajectory of the state of charge of the battery (SOC_ref(t)).

12. A computer program product comprising program code instructions for execution of the steps of the method according to claim 11, when said program is run on a computer.

FIG 1

FIG 2

EP 2 907 212 B1

## RÉFÉRENCES CITÉES DANS LA DESCRIPTION

**Documents brevets cités dans la description**

- US 2012074909 A
- US 2012249078 A